(19) Europäisches Patentamt
European Patent Office
Office européen des brevets

(11) EP 2 405 590 A1

(12) EUROPEAN PATENT APPLICATION
published in accordance with Art. 153(4) EPC

(43) Date of publication:
**11.01.2012 Bulletin 2012/02**

(21) Application number: **10748836.3**

(22) Date of filing: **05.03.2010**

(51) Int Cl.:
***H04B 7/005*** *(2006.01)* ***H03M 13/29*** *(2006.01)*

(86) International application number:
**PCT/JP2010/053651**

(87) International publication number:
**WO 2010/101243 (10.09.2010 Gazette 2010/36)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **06.03.2009 JP 2009053568**

(71) Applicant: **Sharp Kabushiki Kaisha**
**Osaka-shi, Osaka 545-8522 (JP)**

(72) Inventors:
- **SAMPEI Seiichi**
  **Suita-shi**
  **Osaka 565-0871 (JP)**
- **IBI Shinsuke**
  **Suita-shi**
  **Osaka 565-0871 (JP)**
- **MIYAMOTO Shinichi**
  **Suita-shi**
  **Osakac 565-0871 (JP)**
- **YOKOMAKURA, Kazunari**
  **Osaka 545-8522 (JP)**
- **HAMAGUCHI, Yasuhiro**
  **Osaka 545-8522 (JP)**
- **NAKAMURA, Osamu**
  **Osaka 545-8522 (JP)**
- **YOSHIMOTO, Takashi**
  **Osaka 545-8522 (JP)**
- **YAMADA, Ryota**
  **Osaka 545-8522 (JP)**

(74) Representative: **Müller - Hoffmann & Partner**
**Patentanwälte**
**Innere Wiener Strasse 17**
**81667 München (DE)**

# (54) CODER, RECEIVER, WIRELESS COMMUNICATION SYSTEM, PUNCTURE PATTERN SELECTION METHOD, AND PROGRAM THEREFOR

(57) By controlling to select encoding appropriately considering characteristics of equalization and decoding of a receiving apparatus employing a turbo equalization technology, it is possible to attain a high transmission characteristic. Information bits of two systems including a sequence which is input to a first RSC encoding unit 22 and a sequence which is input through an interleaving unit 21 to a second RSC encoding unit 23 are set for input information bits, and each of which is subjected to RSC encoding. Each encoded parity bit is input to a puncturing unit 24. Since a systematic bit obtained by the first RSC encoding unit 22 is the information bit itself, a systematic bit obtained by the second RSC encoding unit 23 is not transmitted. In the puncturing unit 24, while puncturing is applied according to a predetermined coding rate, selection of either an RSC code or a turbo code is carried out by a puncturing control unit 25.

*FIG. 2*

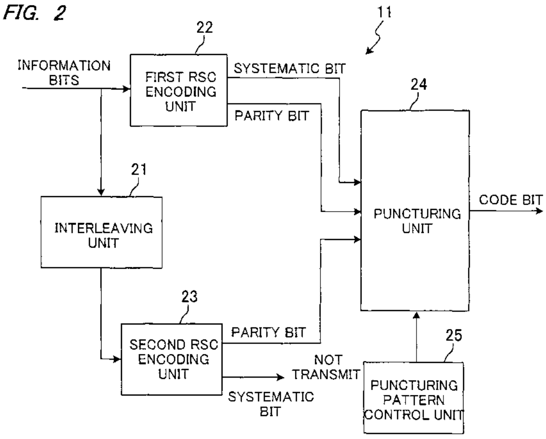


EP 2 405 590 A1

## Description

### Technical Field

The present invention relates to a coding apparatus capable of selecting a turbo code or an RSC code while keeping a coding rate, a receiving apparatus for equalizing and decoding a coded signal that is transmitted, and a wireless communication system provided with a transmitting apparatus and the receiving apparatus.

### Background Art

In recent years, non-linear iterative equalization called turbo equalization attracts attention, and all energies in a multi-path of a radio propagation path are able to be combined in reception processing using a transmission scheme with a single carrier scheme as a base, so that it is possible to obtain excellent characteristics. The transmission scheme with such a single carrier scheme as a base is disclosed in Non-Patent Literature 1 described below and the like.

An example of a receiving apparatus 1000 of frequency domain SC/MMSE (Soft Canceller followed by Minimum Mena Square Error) turbo equalization is shown in FIG. 10. Though a transmitting apparatus is not illustrated here, it is assumed that an information bit is subjected to error correction coding, and after interleaving is applied to a coded bit, a modulation signal is generated and a signal to which CP (Cyclic Prefix) is attached is transmitted.

The CP of a reception signal which is received by a reception antenna and downconverted from carrier frequency is removed by a CP removing unit 1001, followed by conversion into a frequency signal by a first DFT (Discrete Fourier Transform) unit 1002. The obtained reception signal is input to a cancelling unit 1003, and the cancelling unit 1003 cancels the signal in a case where there is priori information fed back from a decoding unit 1008, but the signal is not canceled on the first try. Output from the cancelling unit 1003 is subjected to, for example, equalization processing based on minimum mean square error (MMSE: Minimum Mean Square Error) standard and the like in a frequency domain by an equalizing unit 1004, and is converted into a time signal by an IDFT (Inverse DFT) unit 1005. Next, an LLR (Log Likelihood Ratio) indicative of reliability of a coded bit is output from the time signal after equalization by a demodulating unit 1006, and arrangement of the coded bit is returned to the original arrangement by a deinterleaving unit 1007 in the obtained LLR.

Error correction processing based on maximum a posteriori probability (MAP: Maximum A Posteriori probability) estimation is performed in the decoding unit 1008 to increase reliability of the LLR. Here, in the decoding unit 1008, the LLR of the information bit is output to a determining unit 1012 as well as an "extrinsic" LLR of the coded bit is output to an interleaving unit 1009. Here, "extrinsic" indicates the reliability of the coded bit improved only by the error correction processing and actually has a value obtained by subtracting, the input LLR of the coded bit output from the deinterleaving unit 1007, from the LLR obtained in the inside of the decoding unit 1008. Next, the LLR of the coded bit is input to the interleaving unit 1009 and arrangement of the LLR is rearranged. For the rearranged LLR of the coded bit, a soft replica having amplitude in proportion to the reliability indicated by the LLR is generated by a soft replica generating unit 1010. For example, in a case where a modulation scheme is quaternary phase shift keying (QPSK: Quaternary Phase Shift Keying), when LLRs of 2-bit coded bits constituting a QPSK symbol are $\lambda_1$ and $\lambda_2$, respectively, representation is made by a formula (1).

[Formula 1]

$$s_{soft} = \frac{1}{\sqrt{2}} \tanh\left(\frac{\lambda_1}{2}\right) + j\frac{1}{\sqrt{2}} \tanh\left(\frac{\lambda_2}{2}\right) \quad \cdots \quad (1)$$

Wherein, $S_{soft}$ denotes a soft replica expressed by complex numbers and j denotes an imaginary unit and tanh (x) denotes a hyperbolic tangent function.

Next, the soft replica obtained by the formula (1) is input to a second DFT unit 1011, and a soft replica of a frequency signal is generated and input to the cancelling unit 1003 and the equalizing unit 1004. Inputting to the cancelling unit 1003 and the equalizing unit 1004 is to reduce the number of times of inverse matrix calculation by temporarily canceling all even including desired signals at the cancelling unit 1003 and reconfiguring by using the frequency signal input to the equalizing unit 1004. Processing subsequent to the cancelling unit 1003 is repeated arbitrary number of times again and hard determination is performed on the LLR of the information bit by the determining unit 1012 lastly, so that a decoded bit sequence is obtained.

In this manner, by connecting the equalizing unit and the decoding unit in series and exchanging LLRs of the coded bits mutually obtained from independent constraint conditions, it is possible to enhance reliability of the coded bits gradually, thus improving detection accuracy of information bits. One visually indicating behavior of the iterative processing based on such a turbo principle is an extrinsic information transfer (EXIT: Extrinsic Information Transfer) chart.

FIG. 11(a) shows a model monitoring an EXIT chart in a turbo equalization technology and the same figure (b) shows an example of an EXIT chart by this model. First, in the same figure (a), the model of turbo equalization is configured by an equalizer 2001 and a decoder 2002. The equalizer 2001 has functions of the cancelling unit 1003, the equalizing unit 1004, the IDFT unit 1005, the demodulating unit 1006, the soft replica generating unit 1010 and the second DFT unit 1011 in FIG. 10, and the decoder 2002 has a function of the decoding unit 1008 in FIG. 10. In the same figure (a), an extrinsic LLR output from the equalizer 2001 serves as an input LLR of the decoder 2002, and an extrinsic LLR output from the decoder 2002 serves as an input LLR of the equalizer 2001, resulting in such a model.

FIG. 11(b) is an EXIT chart illustrating behavior of iterative processing. Here, in the EXIT chart, a value called a mutual information content which quantitatively indicates an amount of information which can be known about a transmitted code bit is calculated from an external LLR to show an input-output relationship between the equalizer 2001 and the decoder 2002.

Though various methods are proposed as a method for calculating the mutual information content, for example, in the case of the equalizer 2001, assuming that a power ratio of reception signal to noise after equalization is an SNR (Signal to Noise power Ratio), the mutual information content is calculated by a formula (2).

[Formula 2]

$$I = \left(1 - 2^{-H_1 (4SNR)^{H_2}}\right)^{H_3} \quad \cdots (2)$$

Wherein, I denotes a mutual information content of values from 0 to 1, and $H_1$, $H_2$ and $H_3$ denote coefficients calculated by approximation of curve fitting in which approximation is carried out by the formula (2) so as to minimize minimum mean square error using values obtained by simulation, and are treated as different constant numbers by a modulation scheme. In the case of Gray coding and in the case of binary phase shift keying (BPSK: Binary Phase Shift Keying) and QPSK, $H_1 = 0.3073$, $H_2 = 0.8935$ and $H_3 = 1.1064$, and constant numbers are also able to be calculated similarly in another modulation scheme and signal constellation (for example, the case of signal constellation of multilevel coding is described in Non-Patent Literature 2). Though the input-output relation of the mutual information content of the equalizer 2001 is able to be calculated based on the formula (2), a propagation path actually fluctuates, so that snapshots calculated for each transmission opportunity, amounts of statistics such as a 1 % value and the like are used. For example, in a case where a coding rate is changed so as to follow propagation path fluctuation like in an adaptive coding scheme as shown in Non-Patent Literature 2, snapshots are used. On the other hand, a characteristic of the decoder 2002 is determined depending on a configuration of a coding apparatus for error correction coding, and if the coding apparatus is determined, the characteristic is able to be obtained uniquely and is therefore able to be grasped in advance.

Next, how to see the EXIT chart will be described. In the same figure (b), L2001 denotes an input-output characteristic of the equalizer 2001 and L2002 denotes an input-output characteristic of the decoder 2002. In addition, a vertical axis shows an output mutual information content of the equalizer and an input mutual information content of the decoder, and a horizontal axis shows an input mutual information content of the equalizer and an output mutual information content of the decoder.

First, in the EXIT chart, equalization processing is initially performed in a state where there is no priori information, so that, starting from where the information content is zero, that is, origin (point where both the horizontal axis and the vertical axis are zero) in the same figure, the mutual information content improved by the equalization processing according to an arrow A2001-1 is obtained. Next, since the output mutual information content of the equalizer directly serves as the input mutual information content of the decoder, the mutual information content by decoding is obtained according to an arrow A2002-1. Similarly, the obtained mutual information content is fed back to the equalizer 2001, so that the equalization processing is applied according to an arrow A2001-2, and the mutual information content by decoding is obtained according to an arrow A2002-2. The above processing is repeated, and when it is possible to reach 1 in the horizontal axis eventually, turbo equalization processing is brought into a convergence state, thus enabling detection without error. On the other hand, when the input-output characteristic of the equalizer 2001 crosses the input-output characteristic of the decoder 2002, if analysis is carried out by drawing arrows as described above, the detection error is caused because of stopping at the place of crossing. This state is called "stack", and in the turbo equalization technology, it is necessary to design such a coding apparatus that does not cause the stack.

Meanwhile, whether the stack is caused varies by changing a configuration of the coding apparatus, so that it is possible to design the coding apparatus depending on whether iterative processing is brought into the convergence state when turbo equalization is applied. Since the input mutual information content required for obtaining the output mutual information content of the decoder of 1 is generally small, when the turbo equalization is not used, the turbo code shows more excellent characteristics in many cases. On the other hand, when the input mutual information content is small, an error correction capability of the turbo code itself becomes low, and a convolution code and an RSC (Recursive Systematic Convolutional) code have a higher error correction capability. In this manner, the turbo equalization needs to be brought into the convergence state while improving the mutual information content to some extent by error correction, so that there is also a situation where the RSC code or the like, rather than the turbo code, is more likely to be brought into the convergence state.

This concept is shown in FIG. 12. In the same figure, a horizontal axis shows an input mutual information content of an equalizer and an output mutual information content of a decoder, and a vertical axis shows an output mutual information content of an equalizer and an input mutual information content of a decoder. L3001 denotes an example of an input-output characteristic of a mutual information content of the turbo code when the number of time of the turbo decoding is four times and L3001 denotes an example of an input-output characteristic of a mutual information content of the RSC code. Since the input-output characteristic L3001 of the mutual information content of the turbo code and the input-output characteristic L3002 of the mutual information content of the RSC code have different inclinations, more optimal one may be selected depending on the inclination of the characteristic of the equalizer. This means that when there is a receiving apparatus to which turbo equalization is applicable, it is necessary to appropriately select the configuration of the coding apparatus.

Prior Art Literature

Non-Patent Literatures

Non-Patent Literature 1: M. Tuchler, and J. Hagenauer, "Linear Time and Frequency DomainTurbo Equalization," in Proc. VTC2001-Spring, pp. 1449-1453, May 2001.

Non-Patent Literature 2: S. IBI, T. Matsumoto, R. Thoma, S. Sampei, and N. Morinaga, "EXIT Chart-Aided Adaptive Coding for MMSE Turbo Equalization with Multilevel BICM infrequency Selective MIMO Channels," IEEE Trans. VT, Vol. 56, No. 6, pp. 3749-3756. Nov. 2007.

Summary of Invention

Problems to be Solved by the Invention

However, when a design is made such a way that does not cause stack, it is necessary to select an appropriate code by seeing an input-output characteristic of an equalizer, and an input-output characteristic is greatly different between a case where a convolution code or an RSC code is selected in an encoding apparatus and a case where a turbo code is selected as a coding apparatus, so that it is necessary to select an appropriate code after grasping an input-output characteristic in a transmission time of the equalizer that changes stochastically.

Further, by contrast, next-generation cellular systems such as LTE (Long Term Evolution) and LTE-A, when the turbo code is used, a function exists such that the convolution code is used only for control information because an error correction effect is small if an information bit sequence is not long to some extent, and the turbo code is used for data. This is merely a concept of switching two types of coding apparatuses depending on the length of data and an error correction code in data transmission basically is the turbo code, so that the configuration of the coding apparatus is desirably changed so as to be applied to the RSC code with the configuration for the turbo code remained as much as possible, and there has been no means of changing the configuration of the coding apparatus while being conscious of that a receiving apparatus to which turbo equalization is applicable exists.

In addition, since it is expected that an environment will become such that in a future wireless communication system, not only multi carrier signals such as orthogonal frequency division multiplexing (OFDM: Orthogonal Frequency Division Multiplexing) which does not need equalization in the same system but single carrier signals are mixed, a problem is newly posed that an appropriate coding apparatus must be selected considering not only whether a receiving apparatus which uses turbo equalization is mixed but also which code is appropriate even in a receiving apparatus into which turbo equalization is introduced.

The present invention has been made in view of such circumstances and an object thereof is to provide a coding apparatus capable of achieving a high transmission characteristic by controlling to select coding appropriately considering characteristics of equalization and decoding of a receiving apparatus which employs a turbo equalization technology, a receiving apparatus, a wireless communication system, a puncturing pattern selecting method and a program thereof.

Means for Solving the Problems

The present invention provides an encoding apparatus of a transmitting apparatus that communicates with a receiving apparatus having an equalizing unit and a decoding unit for processing a signal with a turbo equalization technology, comprising:

a first RSC encoding unit for carrying out RSC-encoding on input information bits and outputting a systematic bit and a parity bit; a second RSC encoding unit for carrying out RSC-encoding on a signal with data arrangement different from that of the input information bits and outputting a systematic bit and a parity bit; a puncturing unit for puncturing encoded signals of the first and second RSC encoding units; and a puncturing pattern control unit for controlling the puncturing unit, in which
the puncturing pattern control unit switches, among a puncturing pattern for a turbo code and a puncturing pattern for an RSC code, to one that does not cause the receiving apparatus to be stacked while keeping a coding rate and causes the puncturing unit to carry out puncturing.

Here, it is **characterised in that** the puncturing pattern control unit switches between the puncturing pattern for the RSC code using only an output signal of the first RSC encoding unit and the puncturing pattern for the turbo code using output signals of the first and second RSC encoding units.

Further, it is **characterised in that** the puncturing pattern control unit switches a puncturing pattern in which the number of the parity bit obtained by the first RSC code and a parity bit obtained from the second RSC code is made non-uniform.

Further, it is **characterised in that** the puncturing pattern control unit switches the puncturing pattern based on a used transmission scheme.

Further, the present invention provides a receiving apparatus having an equalizing unit and a decoding unit for processing a signal coded by the encoding apparatus with a turbo equalization technology, comprising:

an inclination calculating unit for calculating inclinations of input-output characteristics of mutual information contents of each of the equalizing unit and the decoding unit; and a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the encoding apparatus.

Here, it is **characterised in that** the puncturing pattern selecting unit selects the puncturing pattern for the RSC code from the puncturing pattern for the turbo code.

Further, the present invention provides a receiving apparatus having an equalizing unit and a decoding unit for processing a signal coded by the encoding apparatus with a turbo equalization technology, comprising:

an inclination calculating unit for calculating inclinations of input-output characteristics of mutual information contents of each of the equalizing unit and the decoding unit; and a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the encoding apparatus, in which
the puncturing pattern selecting unit selects an appropriate one from a plurality of puncturing patterns for changing a transmission rate of parity bits output from first and second RSC encoding units.

Here, it is **characterised in that** the puncturing pattern selecting unit selects a puncturing pattern with a largest inclination among input-output characteristics for a mutual information content of the decoding unit, and the puncturing pattern has a smaller inclination than that of an input-output characteristic for a mutual information content of the equalizing unit.

Further, the present invention provides a receiving apparatus having an equalizing unit and a decoding unit for processing a signal coded by the encoding apparatus with a turbo equalization technology, comprising:

an inclination calculating unit for calculating inclinations of input-output characteristics of mutual information contents of each of the equalizing unit and the decoding unit; and a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the coding apparatus, in which
the puncturing pattern selecting unit selects the puncturing pattern by a used transmission scheme.

Further, the present invention provides a wireless communication system comprising a transmitting apparatus having the encoding apparatus and the receiving apparatus.
Further, the present invention provides a puncturing pattern selecting method used for an encoding apparatus of a transmitting apparatus that communicates with a receiving apparatus having an equalizing unit and a decoding unit for processing a signal with a turbo equalization technology, comprising:

an inclination calculating step of calculating inclinations of input-output characteristics of mutual information contents of each of the equalizing unit and the decoding unit; and a selecting step of comparing the obtained inclinations of input-output characteristics of mutual information contents of each of the equalizing unit and the decoding unit and inclinations of input-output characteristics of mutual information contents of each of a turbo code and an RSC code and selecting a puncturing pattern that does not cause the receiving apparatus to stack.

The present invention may be a program for causing a computer to execute the puncturing pattern selecting method.

Advantages of the Invention

By applying the present invention, even when a receiving apparatus that carries out turbo equalization is mixed, it is possible to change a configuration of the encoder itself to an appropriate one without changing a configuration of an encoding apparatus, thus more excellent transmission characteristics are obtained.
Further, even under an environment where signals of various radio transmission schemes are mixed, by changing a configuration of an encoding apparatus with a similar method, it is possible to select optimum encoding for a receiving apparatus that receives signals of whatever transmission scheme.

Brief Description of Drawings

[FIG. 1] is a block diagram showing an example of a configuration of a transmitting apparatus of a first embodiment;
[FIG. 2] is a block diagram showing an example of a configuration of an encoding unit of the first embodiment;
[FIG. 3] is a view showing an example of a first RSC encoding unit and a second RSC encoding unit constituting the encoding unit;
[FIG. 4] is a view showing an example of an EXIT chart for explaining a concept of changing a puncturing pattern;
[FIG. 5] is a block diagram showing an example of a configuration of a receiving apparatus of the first embodiment;
[FIG. 6] is a view describing a method for switching from a puncturing pattern in which each coding rate is generated for a turbo code to a puncturing pattern for an RSC code with the same coding rate;
[FIG. 7] is a view showing an example of an EXIT chart verified with computer simulation in the first embodiment;
[FIG. 8] is a view showing an example of an EXIT chart verified with computer simulation in a second embodiment;
[FIG. 9] is a view showing an example of a wireless communication system in which multi carrier and single carrier transmitting apparatuses are mixed in a third embodiment;
[FIG. 10] is a block diagram showing an example of a configuration of a conventional receiving apparatus;
[FIGS. 11] (a) is a block diagram showing a model monitoring an EXIT chart in a turbo equalization technology and (b) is a view showing an example of an EXIT chart by this model; and
[FIG. 12] is a view showing an example of an EXIT chart in a turbo code and an RSC code.

Modes for Carrying Out the Invention

Description will hereinafter be given to embodiments of the present invention with reference to accompanying drawings.

[First embodiment]

FIG. 1 is a block diagram showing an example of a configuration of a transmitting apparatus of this embodiment.

This transmitting apparatus 10 is configured by an encoding unit 11, a puncturing pattern detecting unit 12, an interleaving unit 13, a modulating unit 14, a DFT unit 15, a spectral mapping unit 16, an IDFT unit 17, a pilot signal generating unit 18, a pilot signal multiplexing unit 19 and a CP inserting unit 20.

The puncturing pattern detecting unit 12 receives puncturing pattern information (a puncturing pattern selected by the receiving apparatus) transmitted from a receiving apparatus described below to transmit to the encoding unit 11. The encoding unit 11 is a turbo coding apparatus as a configuration and carries out error correction coding on an input information bit and further changes a puncturing pattern while keeping a coding rate based on the puncturing pattern information (which will be described below in detail). The interleaving unit 13 rearranges the order of the information bit and the redundant bit after puncturing and enhances the resistance to burst error. The modulating unit 14 carries out symbol mapping on the information bit and redundant bit after interleaving for modulation and the DFT unit 15 converts signals thereof into frequency signals. The spectral mapping unit 16 carries out mapping by allocating transmission data to each subcarrier to output to the IDFT unit 17. The signals subjected to mapping are converted into time signals by the IDFT unit 17. The pilot signal generating unit 18 generates pilot signals for estimating a propagation path characteristic of a radio propagation path, which are multiplexed with the time signals by the pilot signal multiplexing unit 19. The CP inserting unit 20 inserts CP to the multiplexed signals and generates transmission signals to transmit.

FIG. 2 is a block diagram showing an example of a configuration of the encoding unit of this embodiment, and FIG. 3 is a view showing an example of a first RSC encoding unit 22 and a second RSC encoding unit 23 (both encoding units have the same configuration) constituting the encoding unit of FIG. 2. Here, description will be given with a case of the encoding unit constituting a turbo code with a coding rate of 1/2.

In FIG. 2, the encoding unit 11 basically has the same configuration as that of a conventional turbo coding apparatus and is comprised of an interleaving unit 21, the first RSC encoding unit 22, the second RSC encoding unit 23, a puncturing unit 24 and a puncturing pattern control unit 25. To the puncturing pattern control unit 25, puncturing pattern information detected by the puncturing pattern detecting unit 12 (information transmitted by the receiving apparatus described below) is input. For input information bits, information bits of two sequences including a sequence which is input to the first RSC encoding unit 22 and a sequence which is input through the interleaving unit 21 to the second RSC encoding unit 23 and rearranged randomly are set, and encodings are carried out in the first RSC encoding unit 22 and the second RSC encoding unit 23, respectively. Next, coded bits of the second bit (referred to as parity bits) coded by the first RSC encoding unit 22 and the second RSC encoding unit 23 are input to the puncturing unit 24. Since the first bit (referred to as a systematic bit) obtained by the first RSC encoding unit 22 is the information bit itself, a systematic bit obtained by the second RSC encoding unit 23 is not transmitted. In the puncturing unit 24, puncturing is applied according to a predetermined coding rate, but puncturing is carried out for selecting the RSC code or the turbo code by the puncturing pattern control unit 25 based on the puncturing pattern information detected by the puncturing pattern detecting unit 12.

Next, description will be given for an operation of the puncturing pattern control unit 25. Table 1 shows a puncturing pattern for constituting the turbo code with a coding rate of 1/2.

[Table 1]

| | |
|---|---|
| First bit | 11 |
| Second bit | 10 |
| Third bit | 01 |

In the same table, the first bit, the second bit and the third bit indicate a systematic bit and a parity bit output by the first RSC encoding unit 22 and a parity bit of the second RSC encoding unit 23 in FIG. 2 (hereinafter, referred to as original codes), respectively, and in the table, a bit corresponding to 1 serves as a coded bit and one having 0 is punctured. For example, in a case where 110010 is obtained in the first RSC encoding unit 22 and the second RSC encoding unit 23, when applying to the puncturing pattern of the table 1, 0 in the third bit and 1 in the fifth bit are punctured, and 1100 is output. Note that, when bits obtained in the first and second RSC encoding units 22 and 23 are long, the pattern of the table 1 is iteratively applied.

The configuration of the RSC encoding units 22 and 23 generating the original codes will be described. Here, an example of an RSC code with the constraint length of 4 that is employed as specifications in a next-generation mobile communication system called LTE (Long Term Evolution) is shown. In FIG. 3, the RSC encoding units 22 and 23 are configured by exclusive OR calculating units 26-1, 26-2 and 26-3 and shift registers 27-1, 27-2 and 27-3. First, it is assumed that values saved in the shift registers 27-1, 27-2 and 27-3 in an initial state are 0. The input information bit is output without being coded as a systematic bit. On the other hand, for the input bit, an exclusive OR is calculated by a value of output of the exclusive OR calculating unit 26-2 and the exclusive OR calculating unit 26-1, and when inputting to the shift register 27-1, all shift registers are operated simultaneously, and an exclusive OR of values that have been saved in the shift register 27-1 and the shift register 27-3 and a value of the exclusive OR 26-1 is calculated by the exclusive OR calculating unit 26-3 and a parity bit constraining the input bit is generated.

At the same time, an exclusive OR is also calculated for values that have been input to the shift register 27-2 and the shift register 27-3 in the exclusive OR calculating unit 26-2, and input to the exclusive OR 26-1 for constraining a next input bit. In this manner, each of the RSC encoding units 22 and 23 generates the original codes.

Next, description will be given for a case of changing to an RSC code only by the puncturing pattern control unit 25 without changing the configuration of the encoding unit 11 serving as the turbo coding apparatus shown in FIG. 2. For the RSC code with a coding rate of 1/2, output itself of the first RSC encoding unit 22 may be used, so that the puncturing pattern of the table 1 may be made as the following table 2 for use the configuration without changing.

[Table 2]

| | |
|---|---|
| First bit | 11 |
| Second bit | 11 |
| Third bit | 00 |

The table 2 means that the second RSC encoding unit 23 is not used. This makes it possible to change a function of the encoder only by switching the puncturing patter for generation of the turbo code and the RSC code without changing the configuration of the turbo encoding unit 11.

FIG. 4 shows an example of an EXIT chart describing a concept of changing a puncturing pattern. In the same figure, L21 and L22 denote an input-output characteristic of a mutual information content of a turbo code and an input-output characteristic of a mutual information content of an RSC code, which is same as shown in FIG. 3. L31 denotes an example of an input-output characteristic of a mutual information content indicating performance of an equalizer appropriate to the turbo code and L32 denotes an example of an input-output characteristic of a mutual information content indicating performance of an equalizer appropriate to the RSC code.

First, since the equalizer having an inclination like L31 has a relatively parallel relation with an input-output characteristic L21 of a mutual information content of a turbo code, when the equalizer characteristic exists in an upper position than the decoder characteristic as shown in the figure, a mutual information content of 1 is easily arrived without stack. At this time, when used for the equalizer with the characteristic having an inclination like L32, the inclination of the equalizer is steep so that a possibility of stack is increased as shown in the same figure.

On the other hand, since the equalizer having an inclination like L32 has a relatively parallel relation with an input-output characteristic L22 of a mutual information content of an RSC code, when the equalizer characteristic exists higher than the decoder characteristic, the mutual information content of 1 is easily arrived, but when the turbo code is used for it, the inclination of the input-output characteristic of the turbo code is so small that a possibility of stack in the vicinity where the mutual information content is small is increased as shown in the same figure.

Therefore, depending on the inclination of an input-output characteristic of an equalizer, the puncturing pattern control unit 25 may select either the RSC code or the turbo code and feed back to the encoding unit 11. Next, description will be given for a method for calculating an inclination of an input-output characteristic of an equalizer. Here, though description will be given taking a frequency region SC/MMSE turbo equalization technology as an example, the same is substantially applied even to a case where a technology generally called a turbo equalization technology is employed.

FIG. 5 shows an example of a receiving apparatus. A receiving apparatus 30 is configured by a CP removing unit 31, a pilot signal extracting unit 32, a propagation path estimating unit 33, an inclination calculating unit 34, a puncturing pattern selecting unit 35, a first DFT unit 36, a cancelling unit 37, an equalizing unit 38, an IDFT unit 39, a demodulating unit 40, a deinterleaving unit 41, a decoding unit 42, an interleaving unit 43, a soft replica generating unit 44, a second DFT unit 45 and a determining unit 46. Though ones having the same names as those in FIG. 10 are basically the same, the pilot signal extracting unit 32, the propagation path estimating unit 33, the inclination calculating unit 34 and the puncturing pattern selecting unit 35 are added here, and in general, a function having means for estimating a frequency response of a propagation path from pilot signals normally exists as a well-known technology, so that functions newly added in the present invention are the inclination calculating unit 34 for calculating an inclination of an input-output characteristic of a mutual information content of an equalizer required to control a puncturing pattern and the puncturing pattern selecting unit 35 for selecting whether to take the configuration of the RSC code or the configuration of the turbo code. The selected puncturing pattern is transmitted to the transmitting apparatus 10, and also needs to be used for error correction decoding and is therefore input to the decoding unit 42.

Next, a method for calculating a start point and an end point of an input-output characteristic of a mutual information content of an equalizer will be noted. The start point and the end point correspond to a case where information about a transmission bit is not able to be grasped at all and a case of being able to be grasped fully, thus, based on which, are able to be calculated.

Generally, when equivalent amplitude gain indicating gain for a transmission signal by equalization processing is $\mu$, reception SNRs after equalization at the start point and the end point are calculated by a formula (3) in the case of an MMSE-base type.

[Formula 3]

$$SNR = \frac{\mu}{1-\mu} \quad \cdots (3)$$

Equivalent amplitude gain of the start point and the end point is represented by a formula (4) and a formula (5), respectively.

[Formula 4]

$$\mu_s = \frac{1}{K}\sum_{k=1}^{K}\frac{|H(k)|^2}{|H(k)|^2+\sigma^2} \quad \cdots (4)$$

[Formula 5]

$$\mu_e = \frac{\frac{1}{\sigma^2 K}\sum_{k=1}^{K}|H(k)|^2}{1+\frac{1}{\sigma^2 K}\sum_{k=1}^{K}|H(k)|^2} \quad \cdots (5)$$

Where, H(k) denotes propagation path gain of the complex number of a k-th discrete frequency, K denotes the point number of a frequency signal, and $\sigma^2$ is a thermal noise variance in the receiving apparatus 30. Moreover, $\mu_s$, denotes equivalent amplitude gain of the start point and $\mu_e$ denotes equivalent amplitude gain of the end point, and based on them, the reception SNRs of the start point and the end point are calculated by the formula (3) and mutual information contents are calculated by the formula (2).

When the mutual information contents of the start point and the end point obtained by the formula (2) are $I_s$ and $I_e$, respectively, an inclination of an approximation line of an equalizer is calculated by $I_e$ - Is in the inclination calculating unit 34.

Next, from the inclination obtained in this manner, whether to cause to select the RSC code or select the turbo code is determined. First, the inclination of an input-output characteristic of the RSC code and the inclination of an input-output characteristic of the turbo code are grasped in the receiving apparatus 30. According to FIG. 3, that of the RSC code is about 0.66 and that of the turbo code is about 0.125, and when the inclination of the characteristic of the equalizer is larger than 0.4 which is almost intermediate between the characteristic of the RSC code and the characteristic of the turbo code, the RCS code is selected, and when being smaller than 0.4, the turbo code is selected. Note that, this is an example of a method for selecting a code, and one for changing the configuration by grasping an inclination and changing a puncturing pattern of a coding apparatus is substantially the same.

In this manner, by grasping the inclinations of the input-output characteristics of the mutual information contents of the equalizer, the present invention is able to make stack hardly occur and to transmit information with a high transmission characteristic. In addition, the present invention may be applied adaptively for each transmission opportunity or continuously used for the inclinations set at a first transmission opportunity in subsequent transmission.

Next, description will be given for a method for generating a puncturing pattern of an RSC code from a puncturing pattern for changing a coding rate for a turbo code in the turbo coding apparatus.

As shown in the table 1 of the first embodiment, in the configuration of the turbo code, the configuration of the turbo code constituted by a coding rate of 1/2 is realized by puncturing parity bits alternately. Though only switching is enough if the coding apparatus is provided with puncturing patterns for both the RSC code and the turbo code, it is desired that a puncturing pattern for switching to the RSC code is able to be generated from a puncturing pattern of each coding rate for the turbo code in view of a memory.

Thus, in this embodiment, description will be given for a method for switching from a puncturing pattern for generating each coding rate for the turbo code to a puncturing pattern for the RSC code with the same coding rate in the puncturing pattern selecting unit 35 of the receiving apparatus. First, by the table 1 and the table 2, the RSC code is realized by not using the third bit, that is, the parity bit of the second RSC encoding unit and not transmitting a transmission bit of the third bit necessary for turbo decoding that is essentially used for the turbo code but using the second bit for transmission instead.

Therefore, in the table of the puncturing pattern, realization is made when the puncturing pattern of the second bit is prescribed as a logical disjunction of the second bit and the third bit and third bits are made all 0. An example of this way of thinking is shown in FIG. 6. In FIG. 6, T51 denotes a puncturing pattern for realizing the turbo code with a coding rate of 1/2 as an example and T52 denotes a puncturing pattern for realizing the RSC code with a coding rate of 1/2 that is generated by the method of this embodiment. As shown in the same figure, the logical disjunction of the values of the second bit and the third bit in the turbo code is calculated like T52 (arrow Y11) and third bits are made zero (arrow Y12), so that it is possible to switch to the puncturing pattern T53 by which the RSC code is obtained without changing not only the coding rate but also the configuration of the turbo cording apparatus itself.

According to this embodiment, a memory for increasing the puncturing table becomes minimum, and it is possible to change the configuration itself of the RSC code in the coding apparatus with the turbo code as a base, and to make an appropriate configuration of the code only by changing the puncturing pattern when turbo equalization is applied, thus reducing detection error of transmission signals.

This is actually verified with computer simulation as an EXIT chart and an example of which is shown in FIG. 7. L51 denotes an EXIT chart of a decoder generated by a conventional configuration of a turbo code and L52 denotes an EXIT chart calculated by using switching of the present invention. The performance which is same as shown in FIG. 12 is obtained and it is confirmed that there is an advantage of the present invention.

[Second embodiment]

Though in the first embodiment the configuration of the puncturing pattern of the RSC code and the configuration of the puncturing pattern of the turbo code are switched, an inclination of an input-output characteristic of a mutual information content of a decoder is controlled more specifically by making the number of the parity bits obtained from the first RSC code and the parity bits obtained from the second RSC code non-uniform.

Tables 3 to 6 show an example of puncturing patterns.

[Table 3]

| | |
|---|---|
| First bit | 11 |
| Second bit | 11 |
| Third bit | 00 |

[Table 4]

| | |
|---|---|
| First bit | 111 |
| Second bit | 110 |
| Third bit | 001 |

[Table 5]

| | |
|---|---|
| First bit | 1111 |
| Second bit | 1110 |
| Third bit | 0001 |

[Table 6]

| | |
|---|---|
| First bit | 11111 |
| Second bit | 11110 |
| Third bit | 00001 |

Puncturing patterns shown by the tables 3 to 6 are referred to as Type 0 to Type 3, respectively, and Type 0 is the same as in the first embodiment. They are methods for changing a transmission rate of parity bits output from the first and second RSC codes while keeping the coding rate. As to Type 1 to Type 3, both parity bits generated from the first and second RSC encoders in the turbo encoder are transmitted, so that decoding is carried out by turbo decoding. The result obtained by computer simulation is shown in FIG. 8. The same figure shows that at a low range (near a start point) of a horizontal axis (an input mutual information content of an equalizer and an output mutual information content of a decoder), it is possible to be made to change an input-output characteristic. Thus, realization is enabled, for example, by calculating inclinations of characteristics of decoders in Type 1 to Type 4 and applying the characteristic of the decoder in the Type having the largest inclination among characteristics of decoders in Types having smaller inclinations than those of the equalizer.

In this manner, when much more puncturing patterns are set without changing a coding rate, more specific control is enabled, thus making it possible to configure the code appropriate to turbo equalization.

[Third embodiment]

As a third embodiment, description will be given for an applied environment taking an uplink of a cellular system as an example. FIG. 9 shows an example of a wireless communication system in which multi carrier and single carrier transmitting apparatuses are mixed. In the same figure, it is assumed that in the light of power use efficiency, a first transmitting apparatus (mobile station) 61 carries out transmission by the single carrier, and a second transmitting apparatus (mobile station) 62 carries out transmission by the multi carrier such as OFDM. A receiving apparatus (base station) 63 is able to receive multi carrier signals and receive single carrier signals, and in particular turbo equalization is also applied as processing for receiving single carrier signals.

First, since the first transmitting apparatus (mobile station) 61 is remote from the receiving apparatus (base station) 63 and uses a single carrier scheme with high power use efficiency, the receiving apparatus (base station) 63 carries out reception processing by the turbo equalization. At this time, as described above, the receiving apparatus (base station) 63 calculates an input-output characteristic of a mutual information content of an equalizing unit from a propagation path characteristic and determines whether the RSC code is appropriate or the turbo code is appropriate to feed back to the first transmitting apparatus (mobile station) 61. At this time, as a method for feed back of switching, for example, whether to be the configuration of the RSC code or the configuration of the turbo code is only notified, so that it is possible to address by an increase by 1 bit of control information.

On the other hand, in the case of the second transmitting apparatus (mobile station) 62 which carries out transmission by OFDM, multi carrier transmission becomes parallel transmission of a narrow band sub-carrier, and distortion by a propagation path is thus observed as gain of each sub-carrier, so that equalization processing in the receiving apparatus (receiving station) 63 is not necessary. Therefore, though an evaluation of an EXIT chart is essentially not necessary, in the case of observing as an EXIT chart, input-output characteristic of a mutual information content of an equalizer is able to be treated such that an output mutual information content is always a straight line with a constant inclination of 0, and the turbo code is appropriate. Thus, notification is given to the second transmitting apparatus (mobile station) 62 so as to transmit with the configuration of the turbo code, and the reception processing is such that no equalization including turbo equalization is applied at all.

In this manner, realization is allowed by notifying an appropriate encoder configuration depending on a wireless system, an environment and a transmission scheme and switching a puncturing pattern in the transmitting apparatus, and use of the above-described embodiment 2 makes it possible to change the configuration of an encoder itself without changing the configuration of the encoding apparatus. As a result, a high transmission characteristic is obtained. Thereby, when propagation path estimation is incorporated in the inside of turbo equalization like the iterative propagation path estimation, accuracy of the propagation path estimation also changes by iteration, so that reception processing in which such reception processing is incorporated is also able to be considered similarly in an MIMO (Multiple-Input Multiple-Output) system and the like in which signals are spatially transmitted in parallel using a plurality of transmission/reception antennas. In addition, as assumed in LTE and LTE-A (LTE-Advanced) systems, it is possible to apply to an environment and the like where an LTE-compatible terminal and an LTE-A-compatible terminal are mixed.

Note that, though description has been given in this embodiment with a case where signals transmitted by the single carrier scheme are received by the receiving apparatus to which turbo equalization is applied, without limitation thereto, the encoding apparatus and the receiving apparatus of the present invention are able to be applied in a case of receiving by a receiving apparatus to which iterative processing for carrying out demodulation and decoding while transferring LLR is applied. For example, it is possible to apply to a case where signals transmitted by a W-CDMA or MC-CDMA scheme are received by a receiving apparatus to which an inter-code interference canceller is applied.

In addition, it is possible to apply to a case where signals transmitted by an OFDM scheme are received by a receiving apparatus to which an inter-symbol interference canceller or an inter-carrier interference canceller is applied.

Furthermore, while there is a method prescribed as an LTE encoding apparatus, changing an interleaving pattern called a sub-block interleaver is substantially the same as changing a puncturing patter of the present invention.

The processing for selecting a puncturing pattern according to this embodiment is able to be realized by a computer. In this case, a program describing processing contents of such a function is provided. Then, by executing the program in a computer, the above-described processing function is realized on the computer.

Description of Reference Numerals

| | |
|---|---|
| 10 | transmitting apparatus |
| 11 | encoding unit |
| 12 | puncturing pattern detecting unit |
| 13 | interleaving unit |
| 14 | modulating unit |
| 15 | DFT unit |
| 16 | spectrum mapping unit |
| 17 | IDFT unit |
| 18 | pilot signal generating unit |
| 19 | pilot signal multiplexing unit |
| 20 | CP inserting unit |
| 21 | interleaving unit |
| 22 | encoding unit |
| 22, | 23 RSC encoding unit |
| 24 | puncturing unit |
| 25 | puncturing pattern control unit |
| 26 | exclusive OR calculating unit |
| 27 | shift register |
| 30 | receiving apparatus |
| 31 | CP removing unit |
| 32 | pilot signal extracting unit |
| 33 | propagation path estimating unit |
| 34 | inclination calculating unit |
| 35 | puncturing pattern selecting unit |
| 36 | first DFT unit |
| 37 | cancelling unit |
| 38 | equalizing unit |
| 39 | IDFT unit |
| 40 | demodulating unit |
| 41 | deinterleaving unit |
| 42 | decoding unit |
| 43 | interleaving unit |

| | |
|---|---|
| 44 | soft replica unit |
| 45 | second DFT unit |
| 46 | determining unit |
| 1000 | receiving apparatus |
| 1001 | CP removing unit |
| 1002 | first DFT unit |
| 1003 | cancelling unit |
| 1004 | equalizing unit |
| 1005 | IDFT unit |
| 1006 | demodulating unit |
| 1007 | deinterleaving unit |
| 1008 | decoding unit |
| 1009 | interleaving unit |
| 1010 | soft replica generating unit |
| 1011 | second DFT unit |
| 1012 | determining unit |
| 2001 | equalizer |
| 2002 | decoder |

## Claims

**1.** An encoding apparatus of a transmitting apparatus that communicates with a receiving apparatus having an equalizing unit and a decoding unit for processing a signal with a turbo equalization technology, comprising:

a first RSC encoding unit for carrying out RSC-encoding on input information bits and outputting a systematic bit and a parity bit;
a second RSC encoding unit for carrying out RSC-encoding on a signal with data arrangement different from that of the input information bits and outputting a systematic bit and a parity bit;
a puncturing unit for puncturing encoded signals of the first and second RSC encoding units; and
a puncturing pattern control unit for controlling the puncturing unit,
wherein
the puncturing pattern control unit switches, among a puncturing pattern for a turbo code and a puncturing pattern for an RSC code, to one that does not cause the receiving apparatus to be stacked while keeping a coding rate and causes the puncturing unit to carry out puncturing.

**2.** The encoding apparatus according to Claim 1, wherein the puncturing pattern control unit switches between the puncturing pattern for the RSC code using only an output signal of the first RSC encoding unit and the puncturing pattern for the turbo code using output signals of the first and second RSC encoding units.

**3.** The encoding apparatus according to Claim 1, wherein the puncturing pattern control unit switches a puncturing pattern in which the number of the parity bit obtained by the first RSC code and a parity bit obtained from the second RSC code is made non-uniform.

**4.** The encoding apparatus according to Claim 1 or 2, wherein the puncturing pattern control unit switches the puncturing pattern based on a used transmission scheme.

**5.** A receiving apparatus having an equalizing unit and a decoding unit for processing a signal coded by the encoding apparatus according to Claim 1 or 2 with a turbo equalization technology, comprising:

an inclination calculating unit for calculating inclinations of input-output characteristics of mutual information contents of each of the equalizing unit and the decoding unit; and
a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the encoding apparatus.

**6.** The receiving apparatus according to Claim 5, wherein the puncturing pattern selecting unit selects the puncturing pattern for the RSC code from the puncturing pattern for the turbo code.

**7.** A receiving apparatus having an equalizing unit and a decoding unit for processing a signal coded by the encoding apparatus according to Claim 3 with a turbo equalization technology, comprising:

an inclination calculating unit for calculating inclinations of input-output characteristics of mutual information contents of each of the equalizing unit and the decoding unit; and
a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the encoding apparatus,
wherein
the puncturing pattern selecting unit selects an appropriate one from a plurality of puncturing patterns for changing a transmission rate of parity bits output from first and second RSC encoding units.

**8.** The receiving apparatus according to Claim 7, wherein the puncturing pattern selecting unit selects a puncturing patter with a largest inclination among input-output characteristics for a mutual information content of the decoding unit, the puncturing pattern having a smaller inclination than that of an input-output characteristic for a mutual information content of the equalizing unit.

**9.** A receiving apparatus having an equalizing unit and a decoding unit for processing a signal coded by the encoding apparatus according to Claim 4 with a turbo equalization technology, comprising:

an inclination calculating unit for calculating inclinations of input-output characteristics of mutual information contents of each of the equalizing unit and the decoding unit; and
a puncturing pattern selecting unit for selecting either a puncturing pattern that causes the encoding apparatus to generate an RSC code or a puncturing pattern that causes the encoding apparatus to generate a turbo code so as not to stack the receiving apparatus based on the inclinations obtained by the inclination calculating unit and transmitting it to the encoding apparatus, wherein
the puncturing pattern selecting unit selects the puncturing pattern by a used transmission scheme.

**10.** A wireless communication system comprising a transmitting apparatus having the encoding apparatus according to any one of Claims 1 to 4 and the receiving apparatus according to any one of Claims 5 to 9.

**11.** A puncturing pattern selecting method used for an encoding apparatus of a transmitting apparatus that communicates with a receiving apparatus having an equalizing unit and a decoding unit for processing a signal with a turbo equalization technology, comprising:

an inclination calculating step of calculating inclinations of input-output characteristics of mutual information contents of each of the equalizing unit and the decoding unit; and
a selecting step of comparing the obtained inclinations of input-output characteristics of mutual information contents of each of the equalizing unit and the decoding unit and inclinations of input-output characteristics of mutual information contents of each of a turbo code and an RSC code and selecting a puncturing pattern that does not cause the receiving apparatus to stack.

**12.** A program for causing a computer to execute the puncturing pattern selecting method according to Claim 11.

FIG. 1

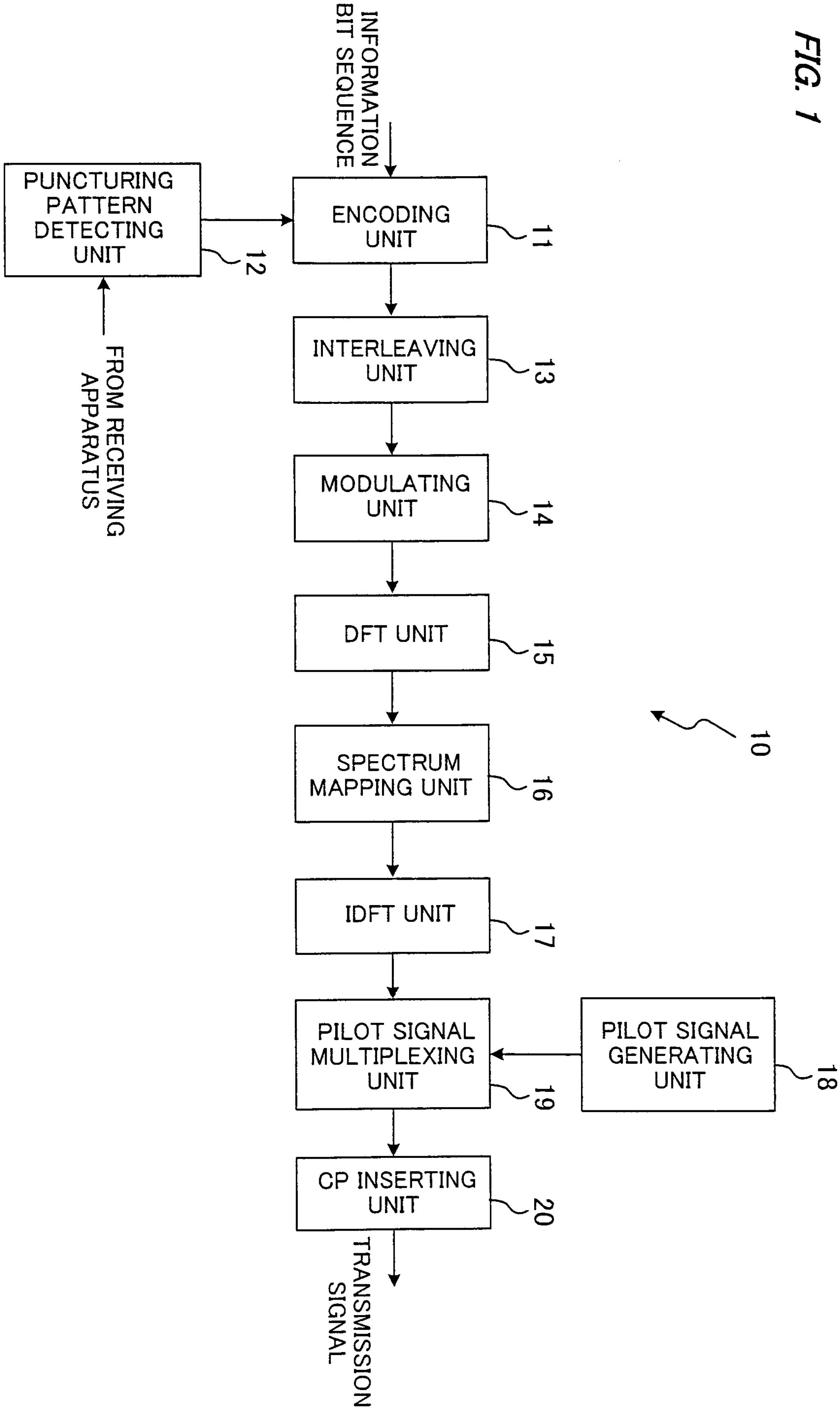
INFORMATION BIT SEQUENCE
PUNCTURING PATTERN DETECTING UNIT
12
FROM RECEIVING APPARATUS
ENCODING UNIT
11
INTERLEAVING UNIT
13
MODULATING UNIT
14
DFT UNIT
15
SPECTRUM MAPPING UNIT
16
IDFT UNIT
17
PILOT SIGNAL MULTIPLEXING UNIT
19
PILOT SIGNAL GENERATING UNIT
18
CP INSERTING UNIT
20
TRANSMISSION SIGNAL
10

FIG. 2

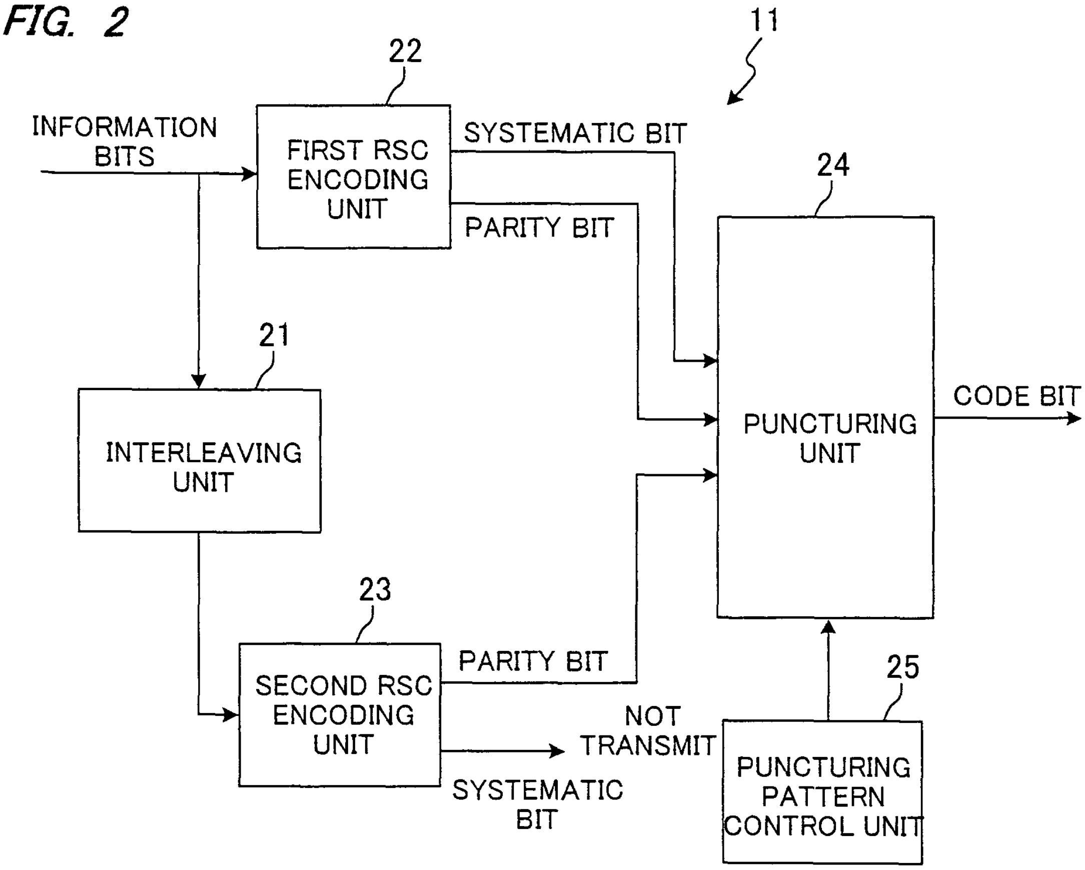
11
22
INFORMATION BITS
FIRST RSC ENCODING UNIT
SYSTEMATIC BIT
PARITY BIT
24
21
INTERLEAVING UNIT
PUNCTURING UNIT
CODE BIT
23
SECOND RSC ENCODING UNIT
PARITY BIT
NOT TRANSMIT
SYSTEMATIC BIT
25
PUNCTURING PATTERN CONTROL UNIT

FIG. 3

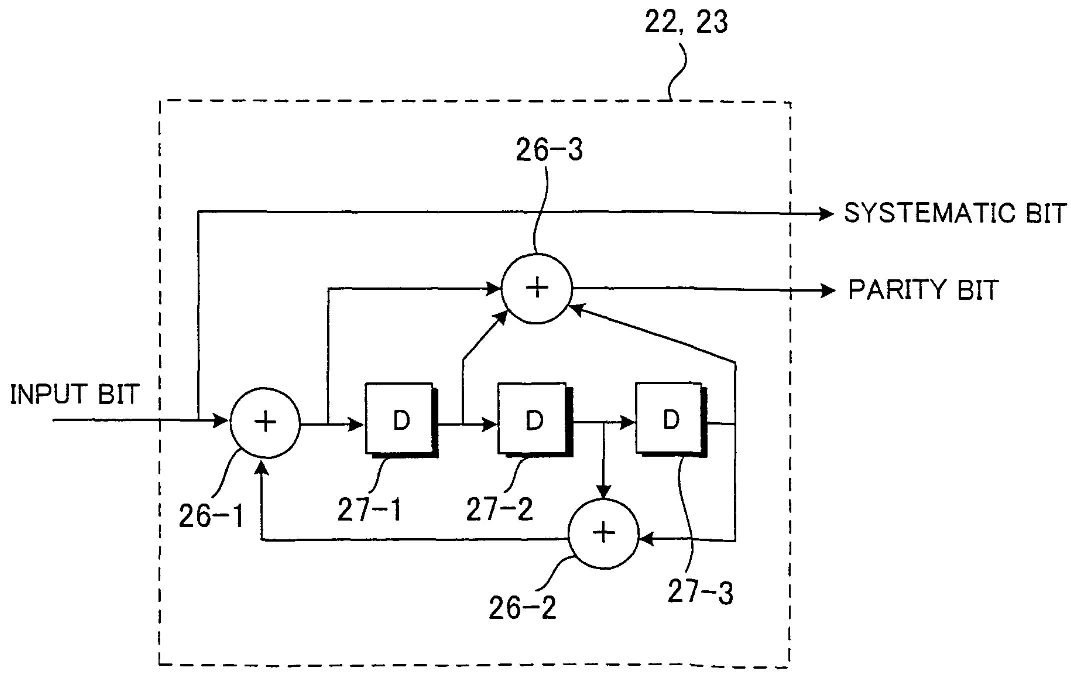
22, 23
26-3
SYSTEMATIC BIT
PARITY BIT
INPUT BIT
D
D
D
26-1
27-1
27-2
26-2
27-3

FIG. 4

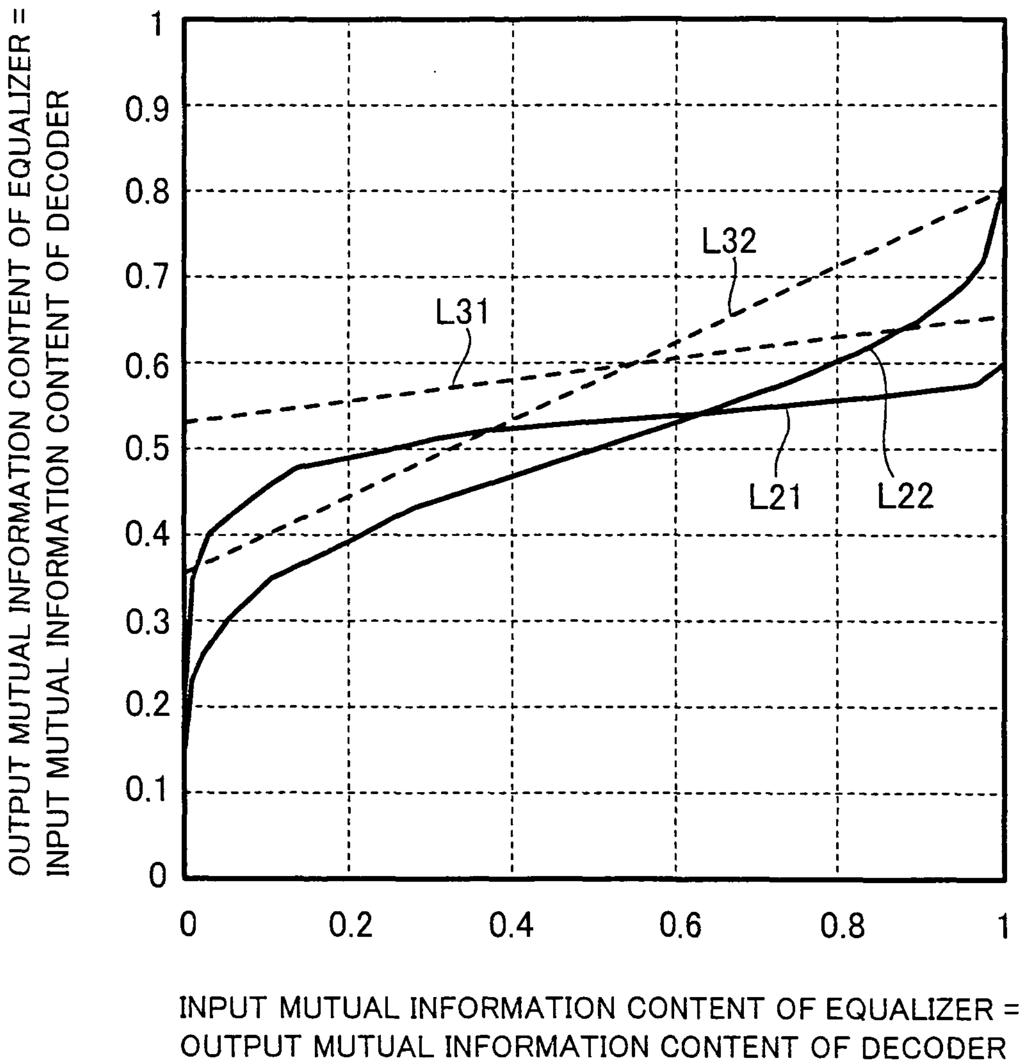
OUTPUT MUTUAL INFORMATION CONTENT OF EQUALIZER =
INPUT MUTUAL INFORMATION CONTENT OF DECODER
1
0.9
0.8
0.7
0.6
0.5
0.4
0.3
0.2
0.1
0
0
0.2
0.4
0.6
0.8
1
L31
L32
L21
L22
INPUT MUTUAL INFORMATION CONTENT OF EQUALIZER =
OUTPUT MUTUAL INFORMATION CONTENT OF DECODER

FIG. 5

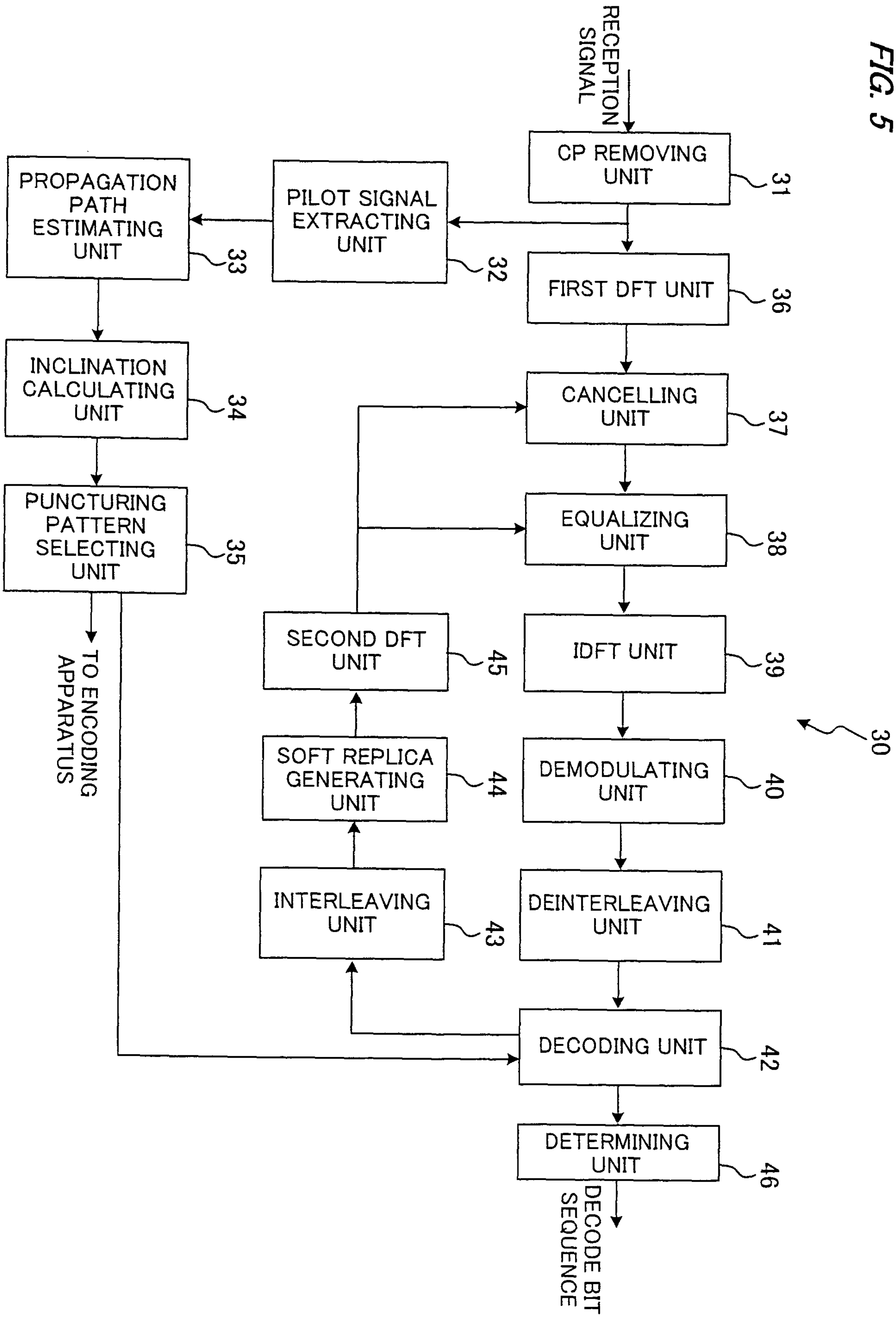
RECEPTION SIGNAL
CP REMOVING UNIT
31
PILOT SIGNAL EXTRACTING UNIT
32
PROPAGATION PATH ESTIMATING UNIT
33
INCLINATION CALCULATING UNIT
34
PUNCTURING PATTERN SELECTING UNIT
35
TO ENCODING APPARATUS
FIRST DFT UNIT
36
CANCELLING UNIT
37
EQUALIZING UNIT
38
IDFT UNIT
39
DEMODULATING UNIT
40
DEINTERLEAVING UNIT
41
DECODING UNIT
42
INTERLEAVING UNIT
43
SOFT REPLICA GENERATING UNIT
44
SECOND DFT UNIT
45
DETERMINING UNIT
46
DECODE BIT SEQUENCE
30

*FIG. 6*

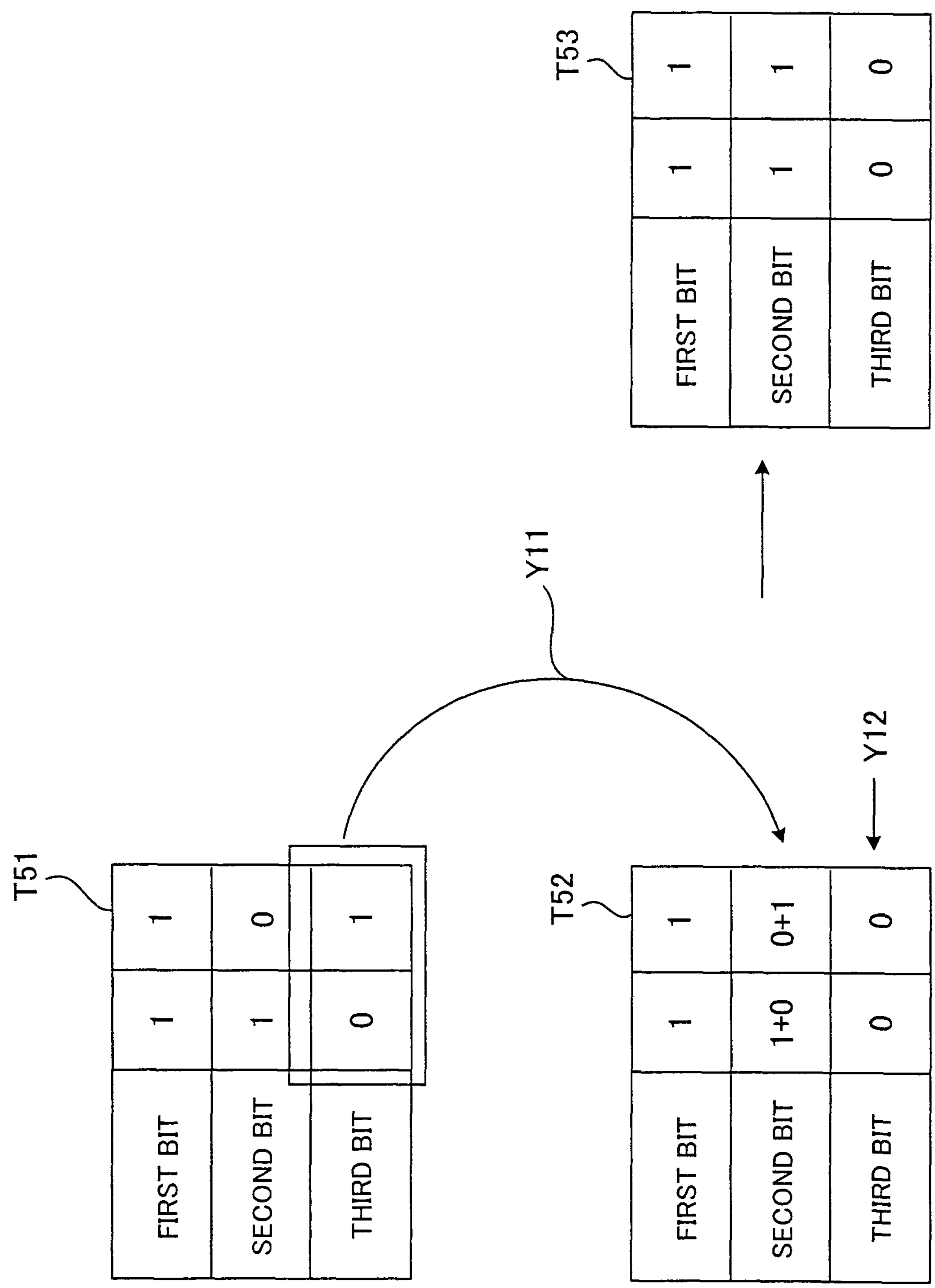
T51
FIRST BIT
SECOND BIT
THIRD BIT
1
1
1
0
0
1
Y11
T52
FIRST BIT
SECOND BIT
THIRD BIT
1
1
1+0
0+1
0
0
Y12
T53
FIRST BIT
SECOND BIT
THIRD BIT
1
1
1
1
0
0

*FIG. 7*

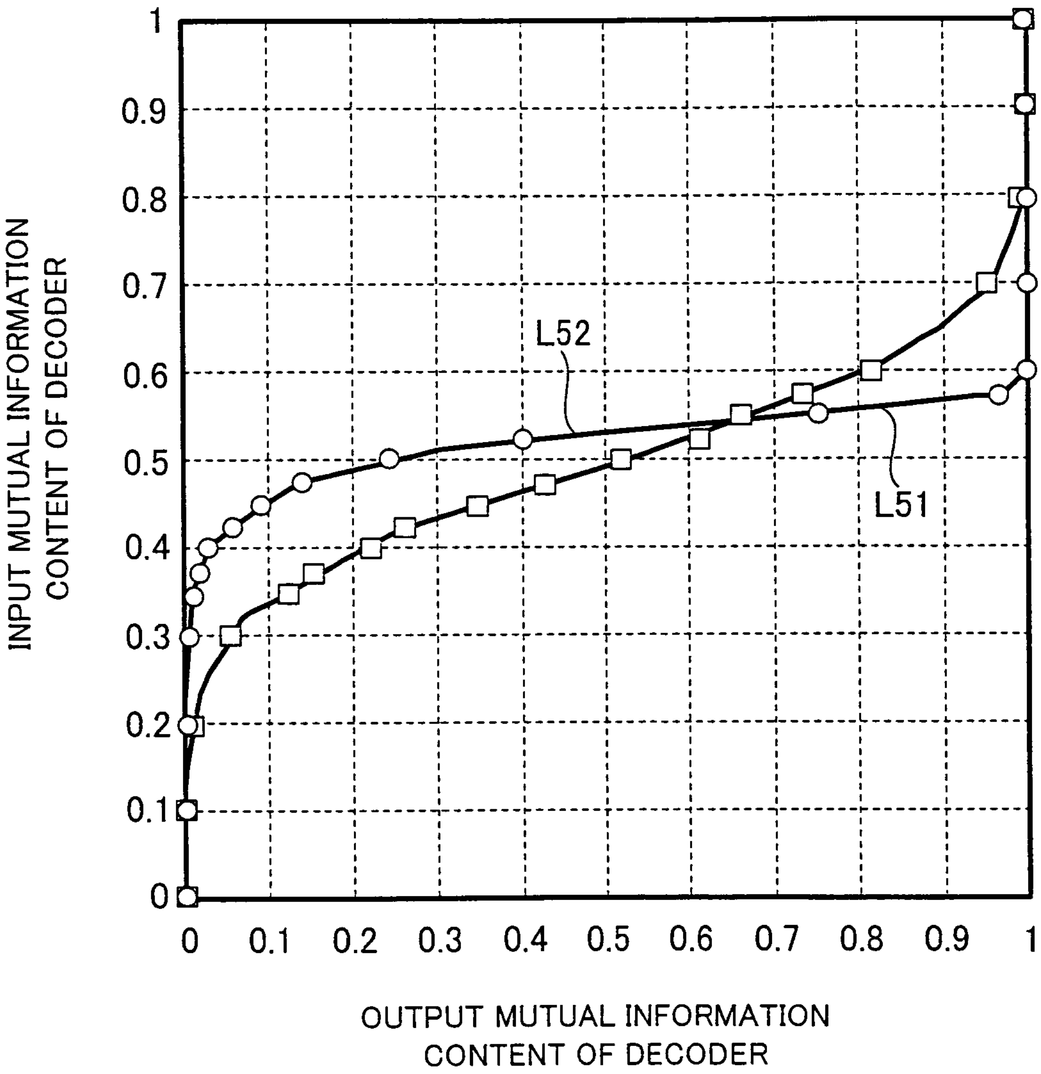
1
0.9
0.8
0.7
0.6
0.5
0.4
0.3
0.2
0.1
0
INPUT MUTUAL INFORMATION CONTENT OF DECODER
L52
L51
0 0.1 0.2 0.3 0.4 0.5 0.6 0.7 0.8 0.9 1
OUTPUT MUTUAL INFORMATION CONTENT OF DECODER

FIG. 8

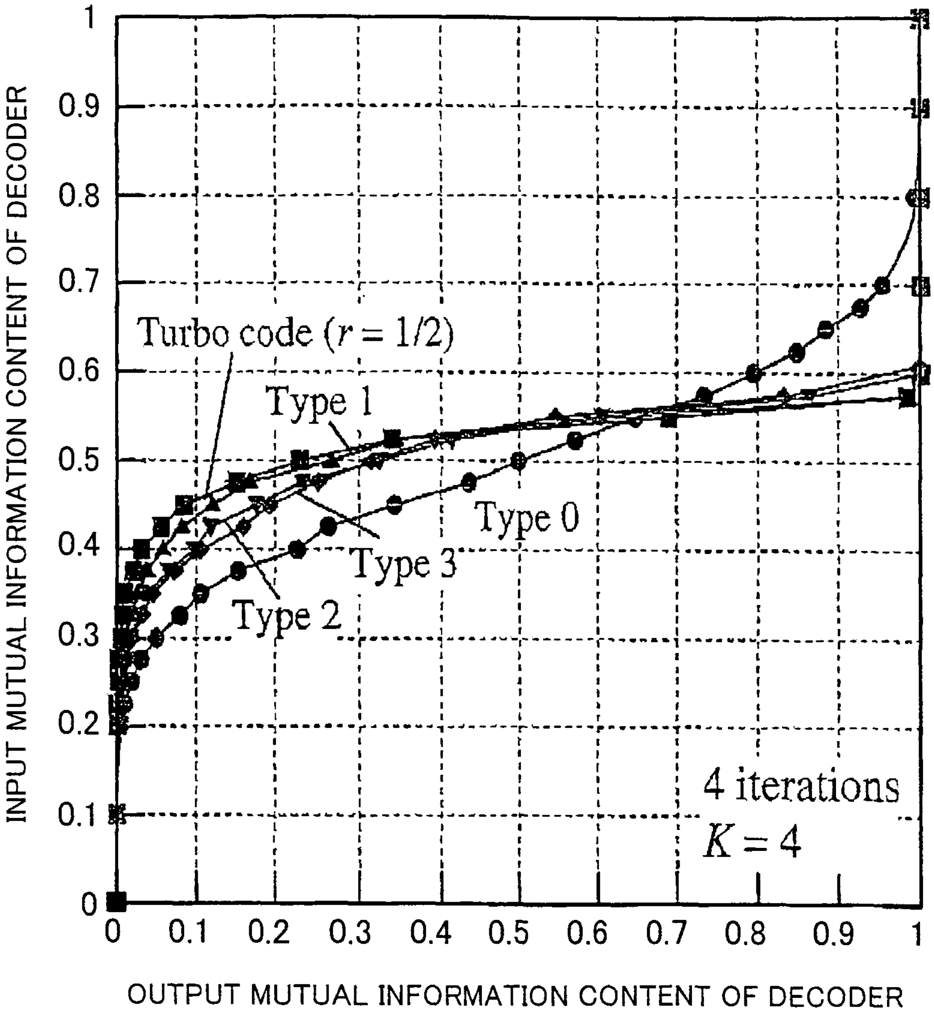
INPUT MUTUAL INFORMATION CONTENT OF DECODER
1
0.9
0.8
0.7
0.6
0.5
0.4
0.3
0.2
0.1
0
Turbo code (r = 1/2)
Type 1
Type 0
Type 3
Type 2
4 iterations
K = 4
0
0.1
0.2
0.3
0.4
0.5
0.6
0.7
0.8
0.9
1
OUTPUT MUTUAL INFORMATION CONTENT OF DECODER

FIG. 9

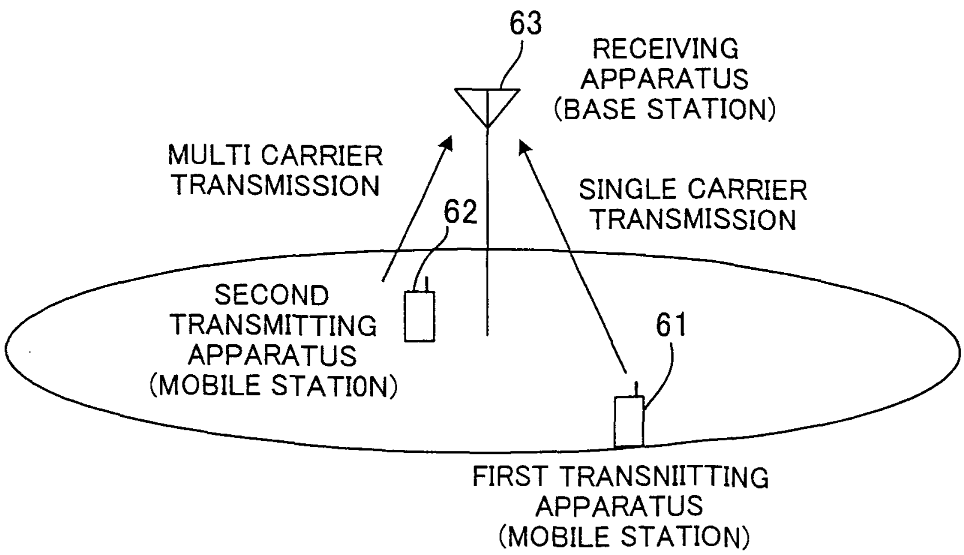
63
RECEIVING
APPARATUS
(BASE STATION)
MULTI CARRIER
TRANSMISSION
SINGLE CARRIER
TRANSMISSION
62
SECOND
TRANSMITTING
APPARATUS
(MOBILE STATION)
61
FIRST TRANSNIITTING
APPARATUS
(MOBILE STATION)

FIG. 10

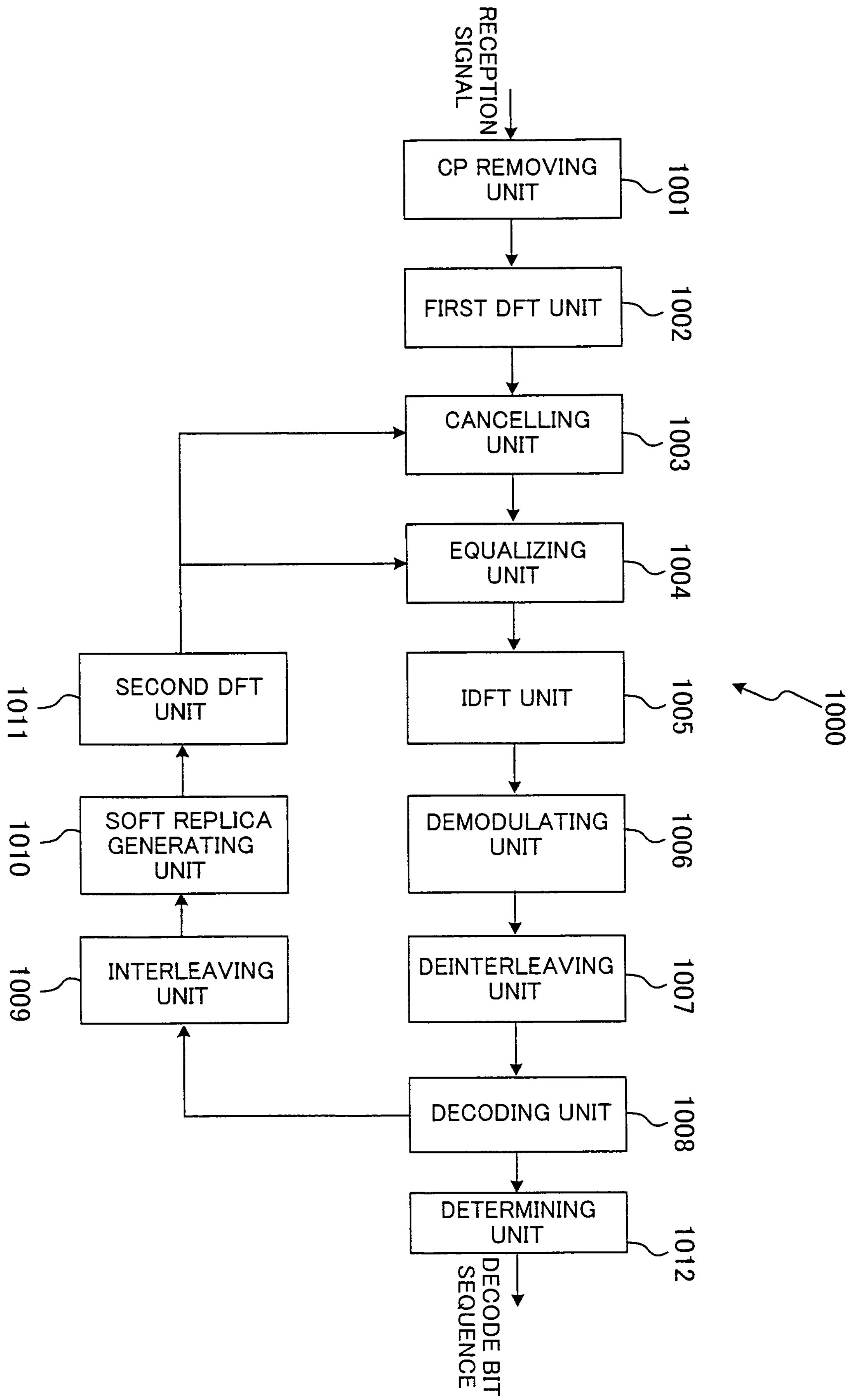
RECEPTION SIGNAL
CP REMOVING UNIT
1001
FIRST DFT UNIT
1002
CANCELLING UNIT
1003
EQUALIZING UNIT
1004
IDFT UNIT
1005
DEMODULATING UNIT
1006
DEINTERLEAVING UNIT
1007
DECODING UNIT
1008
DETERMINING UNIT
1012
DECODE BIT SEQUENCE
INTERLEAVING UNIT
1009
SOFT REPLICA GENERATING UNIT
1010
SECOND DFT UNIT
1011
1000

FIG. 11

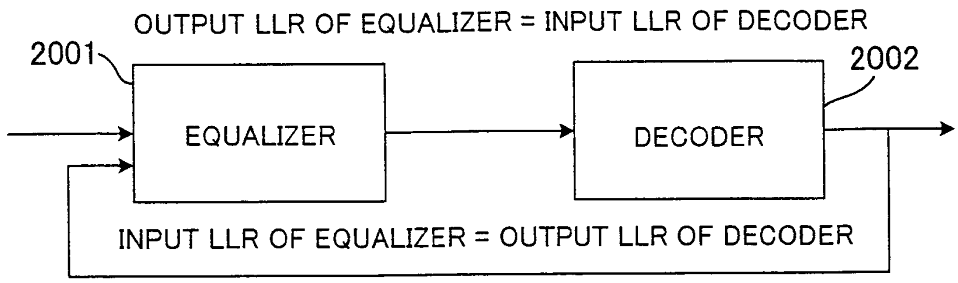
OUTPUT LLR OF EQUALIZER = INPUT LLR OF DECODER
2001
2002
EQUALIZER
DECODER
INPUT LLR OF EQUALIZER = OUTPUT LLR OF DECODER

(a)

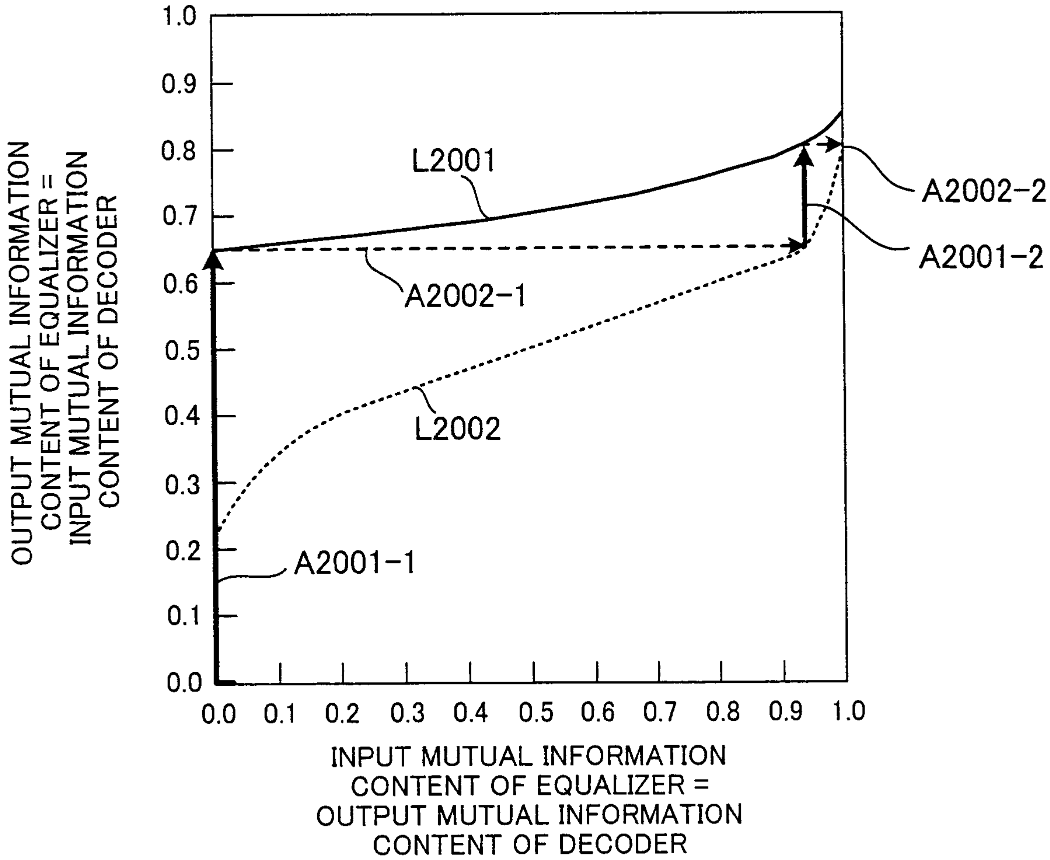
1.0
0.9
0.8
0.7
0.6
0.5
0.4
0.3
0.2
0.1
0.0
L2001
A2002-2
A2001-2
A2002-1
L2002
A2001-1
0.0 0.1 0.2 0.3 0.4 0.5 0.6 0.7 0.8 0.9 1.0
OUTPUT MUTUAL INFORMATION CONTENT OF EQUALIZER = INPUT MUTUAL INFORMATION CONTENT OF DECODER
INPUT MUTUAL INFORMATION CONTENT OF EQUALIZER = OUTPUT MUTUAL INFORMATION CONTENT OF DECODER

(b)

FIG. 12

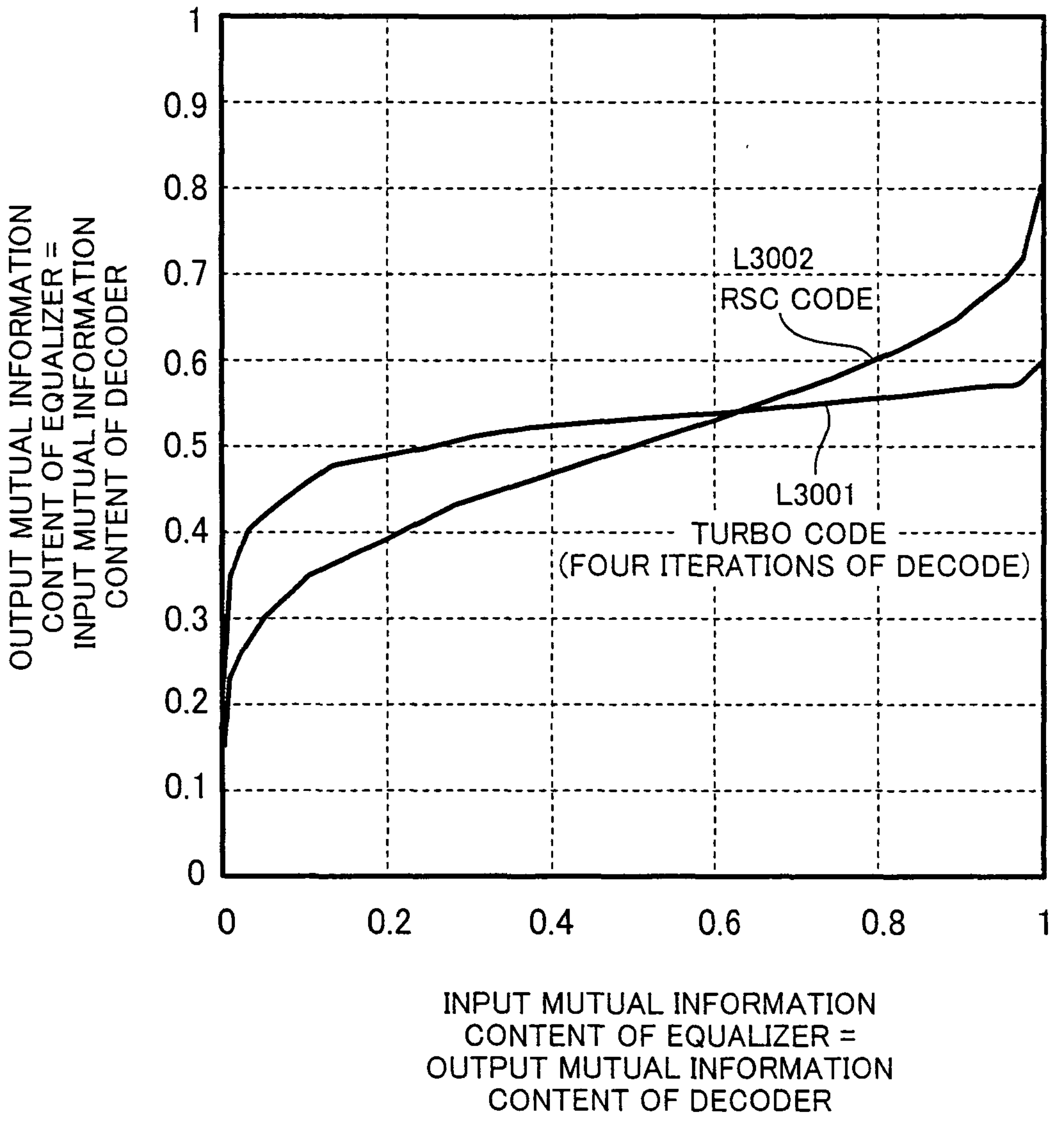
1
0.9
0.8
0.7
0.6
0.5
0.4
0.3
0.2
0.1
0
0
0.2
0.4
0.6
0.8
1
L3002
RSC CODE
L3001
TURBO CODE
(FOUR ITERATIONS OF DECODE)
OUTPUT MUTUAL INFORMATION
CONTENT OF EQUALIZER =
INPUT MUTUAL INFORMATION
CONTENT OF DECODER
INPUT MUTUAL INFORMATION
CONTENT OF EQUALIZER =
OUTPUT MUTUAL INFORMATION
CONTENT OF DECODER

**INTERNATIONAL SEARCH REPORT**

International application No.
PCT/JP2010/053651

A. CLASSIFICATION OF SUBJECT MATTER
*H04B7/005*(2006.01)i, *H03M13/29*(2006.01)i

According to International Patent Classification (IPC) or to both national classification and IPC

B. FIELDS SEARCHED

Minimum documentation searched (classification system followed by classification symbols)
H04B7/005, H04B3/04-3/18, H03M13/00-13/53, H04L1/00, H04L27/00-27/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | WO 2009/022709 A1 (Sharp Corp.),<br>19 February 2009 (19.02.2009),<br>paragraphs [0210] to [0245], [0264] to [0273];<br>fig. 28, 29, 35, 36<br>(Family: none) | 1-4<br>5-12 |
| Y<br>A | JP 2001-514459 A (Siemens AG.),<br>11 September 2001 (11.09.2001),<br>paragraphs [0046] to [0052]; fig. 1<br>& US 6629286 B1 & WO 1999/011013 A1 | 1-4<br>5-12 |
| Y<br>A | JP 2006-510333 A (Interdigital Technology Corp.),<br>23 March 2006 (23.03.2006),<br>paragraphs [0066] to [0067]<br>& US 2004/0187069 A1 & WO 2004/062113 A1 | 3<br>7,8,10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 May, 2010 (20.05.10) | 01 June, 2010 (01.06.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/053651

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-326578 A (Seiko Epson Corp.), 22 November 2001 (22.11.2001), paragraphs [0024] to [0025]; fig. 2 (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **M. Tuchler ; J. Hagenauer.** Linear Time and Frequency DomainTurbo Equalization. *Proc. VTC2001-Spring, pp. 1449-1453,* May 2001
- **S. IBI ; T. Matsumoto ; R. Thoma ; S. Sampei ; N. Morinaga.** EXIT Chart-Aided Adaptive Coding for MMSE Turbo Equalization with Multilevel BICM infrequency Selective MIMO Channels. *IEEE Trans. VT,* November 2007, vol. 56 (6), 3749-3756